# FASCICULE DE BREVET EUROPEEN

(11) **EP 0 825 641 B1**
(45) Date de publication et mention de la délivrance du brevet: **12.03.2008**
(21) Numéro de dépôt: 97401949.9
(22) Date de dépôt: 19.08.1997
(51) Int. Cl.: H01L 21/28, H01L 21/336, H01L 21/60, H01L 21/762

(54) **Procédé de réalistation d'un transistor à contacts auto-alignés**
Verfahren zur Herstellung eines Transistors mit selbstausrichtenden Kontakten
Method of manufacturing a transistor with self aligned contacts

(30) Priorité: 21.08.1996 FR 9610333
(43) Date de publication de la demande: 25.02.1998
(73) Titulaire: COMMISSARIAT A L'ENERGIE ATOMIQUE, 75015 Paris (FR)
(72) Inventeur: Deleonibus, Simon, 38640 Claix (FR)
(74) Mandataire: Poulin, Gérard

(56) Documents cités:
- DE-A- 4 336 869
- US-A- 5 376 578
- PATENT ABSTRACTS OF JAPAN vol. 012, no. 077 (E-589), 10 mars 1988 -& JP 62 216268 A (FUJITSU LTD), 22 septembre 1987,
- PATENT ABSTRACTS OF JAPAN vol. 095, no. 004, 31 mai 1995 -& JP 07 014916 A (NEC CORP), 17 janvier 1995,

## Description

### Domaine technique

La présente invention concerne un procédé de réalisation d'un transistor à contacts auto-alignés sur un substrat de silicium.

Le procédé de l'invention concerne en particulier la fabrication de transistors à effet de champ du type à grille isolée, tels que, par exemple, des transistors MOS (Metal-Oxyde-Semiconductor).

L'invention trouve des applications dans les domaines de la microélectronique et notamment pour la fabrication de circuits intégrés avec une forte densité d'intégration.

### Etat de la technique antérieure

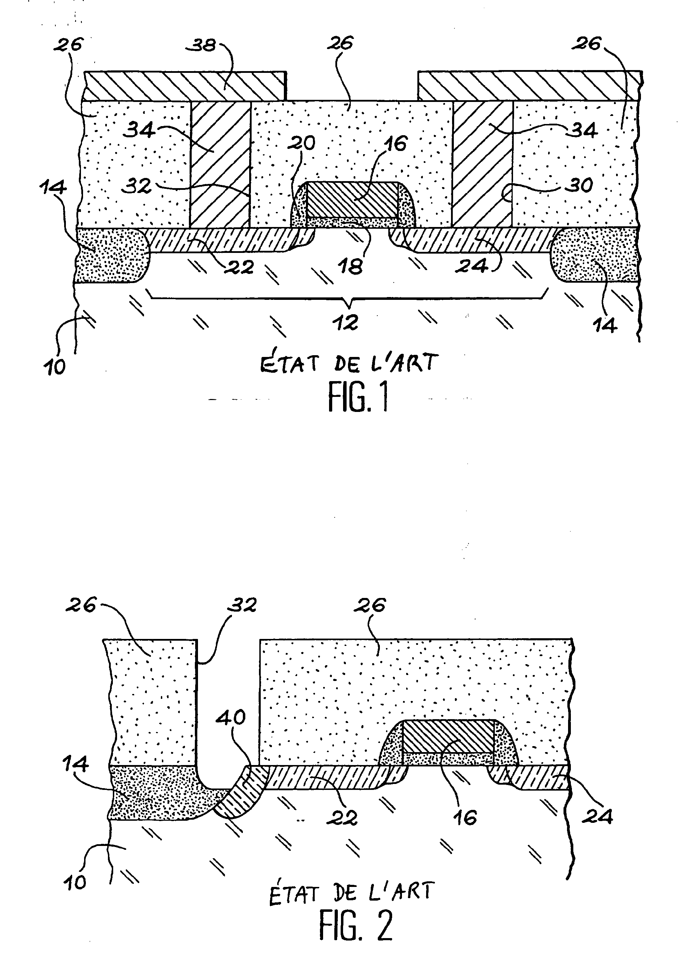

La figure 1 des dessins annexés représente, de façon schématique et en coupe, la structure d'un transistor à effet de champ d'un type connu.

Dans un substrat de silicium 10, une région active 12 est latéralement délimitée par un ou plusieurs pavés d'isolation de champ, repérés avec la référence 14. Les pavés d'isolation de champ 14, en oxyde de silicium, sont fabriqués en soumettant le substrat 10 à une oxydation sélective dans des zones entourant la (ou les) région(s) active(s). Lors de cette oxydation, les régions actives sont généralement protégées par un masque de nitrure de silicium.

Une grille 16 du transistor, formée au-dessus de la région active 12, est séparée du substrat 10 par une couche d'oxyde de grille 18. Les flancs latéraux de la grille 16 sont isolés par des espaceurs latéraux 20.

Une double implantation d'impuretés dopantes dans la région active 12 du substrat 10 permet d'y former des régions de source 22 de drain 24. Une première implantation faible dose est effectuée en utilisant simplement la grille 16 comme masque d'implantation. Puis, une seconde implantation, a plus forte dose, est effectuée après la formation des espaceurs latéraux. Lors de la deuxième implantation, l'ensemble formé par la grille et des espaceurs latéraux est utilisé comme masque de gravure. Cette double implantation permet d'obtenir des régions de source et de drain avec une concentration graduelle.

Après la formation de la grille 16 et des régions 22, 24 de source et de drain l'ensemble de la structure est recouvert d'une épaisse couche 26 de matériau isolant à base de dioxyde de silicium.

Des ouvertures 30, 32 sont pratiquées dans la couche de matériau isolant 26, sensiblement à l'aplomb des régions 22, 24 de source et de drain. Les ouvertures sont enfin emplies d'un matériau conducteur électrique 34, en contact électrique sur les régions de source et de drain. Le matériau conducteur constitue alors des prises de contact.

Des lignes d'interconnexion, indiquées avec la référence 38, formées sur la couche 26 de matériau isolant, sont reliées au matériau conducteur électrique 34. Elles permettent d'interconnecter différents composants formés sur le même substrat.

Une telle structure, et son procédé de fabrication, sommairement décrit ci-dessus, présentent un certain nombre de limitations dans une perspective de miniaturisation des composants et des circuits intégrés.

En effet, les ouvertures 30, 32 et les prises de contact qui y sont pratiquées présentent un encombrement important. Cet encombrement est l'un des obstacles majeurs à la miniaturisation.

L'encombrement global des prises de contact comprend non seulement l'encombrement lié directement à la taille des ouvertures 30 et 32 mais aussi un encombrement lié à une distance minimale qu'il est nécessaire de préserver d'une part entre les prises de contact et la grille 16 et, d'autre part, entre les prises de contact et l'isolation de champ 14.

Ces distances minimales sont en particulier liées à la résolution des outils de photolithogravure utilisés pour définir des masques de gravure lors de la réalisation des ouvertures 30 et 32. De façon pratique, pour compenser les limitations dues à la résolution des outils on agrandit les zones diffusées sur lesquelles on réalise les prises de contact. Ceci apparaît par exemple sur une figure du document "Status, trends, Comparison and Evolution of EPROM and FLASH EPROM Technologies" de A. Bergemont pages 575-582 Proc. 23rd ESSDERC, Grenoble Septembre 1993.

La miniaturisation des transistors et des circuits formés avec ces transistors requiert l'utilisation d'outils de grande précision et entraîne donc des coûts de fabrication élevés.

La figure 2 des dessins montre les conséquences d'une erreur d'alignement des prises de contact sur une région de drain ou de source d'un transistor. Dans l'exemple de la figure 2, une ouverture de prise de contact est décalée vers une couche d'isolation latérale.

Afin de simplifier la description de la figure 2, des parties identiques ou similaires à celles de la figure 1 portent les mêmes références numériques et on peut, par conséquent, se reporter à leur sujet, à la description qui précède.

La figure 2 ne montre qu'une seule prise de contact réalisée sur une région de source 22, cependant le raisonnement qui suit peut être conduit également pour une prise de contact de drain.

Comme le montre la figure 2, le bord supérieur de l'oxyde de champ 14 tourné vers la source 22 a été entamé lors de la gravure de l'ouverture de contact 32 dans la couche d'isolant 26. En effet, la couche 26 et l'oxyde de champ 14 sont tous deux à base d'oxyde de silicium et la gravure définissant les ouvertures des prises de contact ne présente pas une bonne sélectivité de l'une de ces parties par rapport à l'autre.

Ainsi, au fond des ouvertures des prises de contact il se présente le risque d'un contact direct entre un matériau conducteur formé dans ces ouvertures pour constituer les prises de contact, et le substrat 10. Ceci entraîne un risque de court-circuit systématique avec le substrat dans les régions de source et de drain.

Par ailleurs, même dans le cas où l'oxyde de champ n'est que partiellement entamé, comme sur le dessin de la figure 2, la qualité de l'isolation qu'il procure se trouve réduite.

Pour limiter les effets négatifs du désalignement des ouvertures de contact et du chevauchement de ceux-ci sur les régions d'oxyde de champ, il est possible d'effectuer un dopage des parties du substrat situées sous les ouvertures des prises de contact. Un tel dopage est indiqué avec la référence 40 sur la figure 2. Il a pour effet de prolonger en quelque sorte la région de source 22 sous l'ouverture de prise de contact 32. Ainsi, lorsque cette ouverture est comblée d'un matériau conducteur, ce matériau n'est pas directement en contact avec le substrat 10.

Ces mesures sont complexes et n'apportent qu'une solution partielle au problème posé.

Il est connu du document DE 4 336 869 un procédé de fabrication d'un transistor MOS. Ce procédé comprend, entre autres étapes, les étapes de formation sur un substrat d'un empilement de couches ayant une couche d'oxyde, une couche de polysicilium dopé et une couche de nitrure, de gravure de l'empilement selon un premier masque avec arrêt sur la couche d'oxyde, de formation d'une couche isolante sur les parois latérales de l'empilement gravé et d'oxydation du substrat pour former des couches d'oxyde de champ dans le substrat. Une région de source/drain de faible concentration et une région de source/drain de haute concentration sont ensuite réalisées dans le substrat par gravure selon un second masque, implantations ioniques et traitements thermiques.

La présente invention a, par conséquent, pour but de proposer un procédé de fabrication d'un transistor dans lequel les problèmes évoqués ci-dessus n'apparaissent pas.

L'invention a en particulier pour but de proposer un procédé de fabrication d'un transistor dans lequel une séparation physique entre les prises de contact et le bord des oxydes de champ est automatiquement assurée quelle que soit l'épaisseur de ces oxydes de champ.

Un autre but est de proposer un procédé permettant de réaliser des transistors davantage miniaturisés et par conséquent des circuits avec une plus forte densité d'intégration.

Un but est aussi de proposer un procédé qui permette de s'affranchir dans une large mesure des contraintes liées à la résolution des outils de photolithogravure utilisés.

### Exposé de l'invention

Pour atteindre les buts mentionnés ci-dessus, l'invention a plus précisément pour objet un procédé de réalisation d'un transistor à contacts auto-alignés sur un substrat, comprenant les étapes successives suivantes :
a) formation sur le substrat d'un empilement de couches comprenant dans l'ordre une couche dite d'oxyde de grille, une couche de grille, et au moins une couche de protection,
b) formation d'un premier masque de gravure sur l'empilement, le masque présentant au moins un motif correspondant à une région active d'un transistor, et gravure de l'empilement, selon le premier masque, avec arrêt sur la couche d'oxyde de grille, en préservant au moins une colonne de l'empilement, correspondant au motif de ladite zone active,
c) formation d'espaceurs latéraux sur les flancs de la colonne et implantation d'impuretés dopantes aptes à favoriser une oxydation, dans une région du substrat de silicium non masquée par la colonne et les espaceurs latéraux,
d) oxydation localisée du substrat de silicium dans la région implantée et élimination des espaceurs latéraux et de la couche de protection, pour former une couche d'isolation de champ (oxyde),
e) dépôt d'une couche de matériau isolant enrobant la colonne et polissage de la couche de matériau isolant avec arrêt sur la colonne de l'empilement,
f) formation d'un deuxième masque avec un motif de grille et gravure de la colonne selon le deuxième masque avec arrêt sur la couche d'oxyde de grille pour former une structure de grille avec des deuxièmes flancs, et pour mettre à nu des troisièmes flancs délimitant la région active,
g) formation d'espaceurs latéraux isolants auto-alignés sur les deuxième et troisième flancs, implantation de source et de drain dans le substrat de silicium de part et d'autre de la structure de grille dans des régions où l'oxyde de grille est mis à nu par la gravure de la colonne, et
h) élimination de l'oxyde de grille mis à nu et formation de prises de contact sur les source et drain, auto-alignées sur la structure de grille.

Grâce à l'oxydation localisée du substrat dans la région implantée, ainsi qu'aux espaceurs latéraux formés sur les flancs de la colonne, la région oxydée qui forme l'isolation de champ de part et d'autre de la région active est espacée des régions de drain et de source.

Par ailleurs, comme les prises de contact sont auto-alignées sur la structure de grille et les troisièmes flancs qui délimitent la région active, une distance de garde est ménagée entre ces prises de contact et l'isolation de champ. Les prises de contact sont de ce fait également auto-alignées par rapport à l'isolation de champ. Une distance de garde est également ménagée entre les prises de contact et la grille.

Les distances de garde peuvent être ajustées aisément en jouant sur l'épaisseur des espaceurs latéraux, et éventuellement l'implantation d'impuretés (n ou p) dopantes lors de l'étape c). De plus, l'ajustage des distances de garde n'est pas tributaire des dispersions de cotes ou d'éventuels défauts d'alignement des moyens de photolithographie.

Selon un perfectionnement avantageux de l'invention, le procédé peut comporter en outre après l'étape e), la formation d'une couche dite de shunt, en contact avec la couche de grille de la colonne et recouvrant la couche de matériau isolant. Le deuxième masque est formé au-dessus de la couche de shunt et la couche de shunt est également gravée lors de l'étape f) pour faire partie de la structure de grille.

La couche de shunt, lorsqu'elle est mise en forme, peut constituer une ligne d'adressage de la grille du transistor, telle que, par exemple, une ligne de mots dans une mémoire à lecture seule (on peut se reporter à titre d'illustration au document (1)).

Selon un autre aspect de l'invention, lors de l'étape a), on peut former sur l'empilement une première couche de protection d'oxyde de silicium et une deuxième couche de protection de nitrure de silicium recouvrant la couche d'oxyde de silicium,
la deuxième couche de protection de nitrure de silicium étant éliminée lors de l'étape d),
et la première couche de protection étant éliminée lors de l'étape e).

De façon avantageuse, on peut former au-dessus de la couche de shunt une couche isolante électrique, la couche isolante électrique étant gravée avec la couche de shunt lors de l'étape f). On peut noter que les espaceurs formés lors de l'étape g) recouvrent aussi les flancs de la couche de shunt. Ainsi, la couche de shunt est isolée sur le dessus par la couche isolante et sur ses côtés latéraux par les espaceurs latéraux isolants formés lors de l'étape g).

Avec ces mesures, les prises de contact peuvent être formées aisément par un dépôt conforme d'une couche de métal venant en contact avec les source et drain, le polissage de cette couche de métal avec arrêt sur la couche isolante électrique recouvrant la couche de shunt, et la mise en forme de la couche de métal.

Selon un autre aspect de l'invention, avant la formation d'espaceurs latéraux sur les flancs de la colonne, lors de l'étape c), on peut former sur ces flancs une couche d'oxyde de flancs, le côté de la couche d'oxyde de flancs tourné vers la colonne étant mis à nu lors de l'étape f) pour former les troisièmes flancs délimitant la région active.

Cette caractéristique est particulièrement avantageuse lorsque le matériau de grille est du silicium ou du polysilicium. Dans ce cas en effet, la couche d'oxyde de flancs permet de relâcher des contraintes pouvant apparaître entre les espaceurs latéraux, en nitrure de silicium par exemple, et la grille. Ces contraintes sont susceptibles d'apparaître notamment lors de traitements thermiques de la structure au cours du procédé, tel qu'un fluage du matériau isolant déposé lors de l'étape e) ou encore un recuit d'activation de l'implantation ionique source et drain. Le rôle de la couche d'oxyde de silicium peut ainsi être assimilé à celui d'un tampon mécanique.

Pour la mise en oeuvre du procédé de l'invention, il est possible, par exemple, d'utiliser un substrat de silicium massif ou un substrat de type silicium sur isolant SOI (Silicon On Insulator) comprenant un empilement d'une couche de silicium superficielle sur une couche d'oxyde de silicium dite couche enterrée.

Dans le cas d'un substrat de type SOI, l'empilement formé à l'étape a) du procédé est formé sur la couche superficielle de silicium.

D'autres caractéristiques et avantages de l'invention ressortiront mieux de la description qui suit, en référence aux dessins annexés, donnée à titre purement illustratif et non limitatif.

### Brève description des figures.

- La figure 1, déjà décrite, est une coupe schématique d'un transistor d'un type connu,
- la figure 2, déjà décrite, est une coupe schématique d'un détail d'un transistor de type connu illustrant le résultat d'une erreur d'alignement d'une ouverture de prise de contact sur une région de source (ou de drain) de ce transistor,
- la figure 3 est une coupe schématique d'une structure obtenue au terme d'une première étape du procédé de l'invention correspondant à la formation d'un empilement de couches,
- la figure 4 est une coupe schématique d'une structure obtenue au terme d'une deuxième étape du procédé de l'invention correspondant à une première gravure de l'empilement,
- la figure 5 est une coupe schématique d'une structure obtenue au terme d'une troisième étape du procédé de l'invention,
- les figures 6 et 7 sont des coupes schématiques d'une structure illustrant une quatrième étape du procédé de l'invention,
- la figure 8 est une coupe schématique d'une structure obtenue au terme d'une cinquième étape du procédé de l'invention et correspond au dépôt d'un matériau isolant entourant la région active du transistor en fabrication,
- la figure 9 est une coupe schématique de la structure de la figure 6 sur laquelle on a formé un matériau dit de shunt,
- La figure 10 est une coupe schématique de la structure de la figure 9 selon un plan de coupe perpendiculaire au plan de coupe des figures précédentes et illustre la gravure d'une structure de grille,
- la figure 11 est une coupe schématique d'un transistor obtenu au terme du procédé de l'invention et illustre la formation de prises de contact sur les régions de source et de drain de ce transistor,
- la figure 12 correspond à la figure 3 ; il s'agit d'une coupe schématique de la structure obtenue au terme d'une première étape du procédé de l'invention dans laquelle on a formé un empilement sur un substrat de type SOI,
- les figures 13 et 14 correspondent aux figures 8 et 9 et sont des coupes schématiques illustrant des étapes du procédé de l'invention,
- la figure 15 est une coupe schématique selon un plan de coupe perpendiculaire au plan de coupe des figures 12 à 14 et montre un transistor obtenu sur un substrat de type SOI, conformément au procédé de l'invention.

### Description détaillée de modes de mise en oeuvre de l'invention

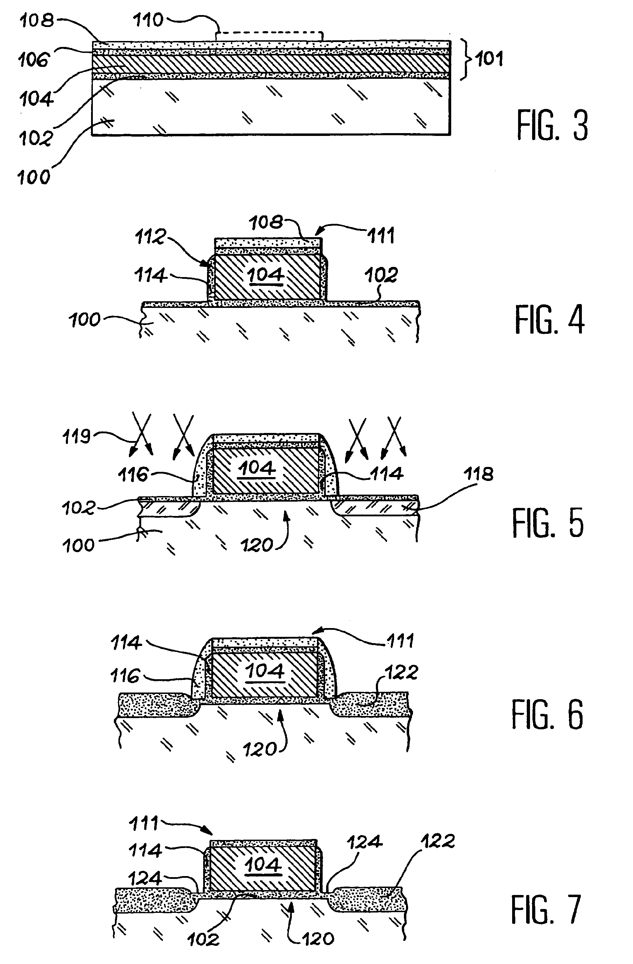

La figure 3 correspond à une première étape du procédé.

Comme le montre la figure, on forme sur un substrat 100, en silicium, un empilement 101 comprenant une couche d'oxyde de grille 102, une couche de grille en silicium polycristallin (polysilicium) 104 constituant le matériau de grille, une fine couche d'oxyde de silicium 106 formant une première couche de protection et une couche de nitrure de silicium 108 formant une deuxième couche de protection de la couche de grille 104.

La couche 102 d'oxyde de grille peut être formée directement par oxydation thermique du substrat de silicium 100.

Les couches 104, 106 et 108 sont ensuite successivement déposées.

La couche 106 de SiO₂, présente une épaisseur fine comprise, par exemple, entre 10 nm et 50 nm et permet, en particulier, de limiter la contrainte sur la zone active lors de l'oxydation de flancs et servir de couche d'arrêt lors de l'élimination de la deuxième couche de protection 108.

La référence 110 de la figure 3 désigne un premier masque de gravure, représenté en trait discontinu. Il s'agit par exemple d'un masque de résine photosensible formé selon des techniques connues de photolithographie.

Ce masque présente un motif qui définit l'emplacement et la taille de la région active (drain, canal, source) du transistor que l'on souhaite réaliser.

Dans le mode de réalisation illustré, un seul masque de gravure est représenté. Il correspond à la fabrication d'un unique transistor. Toutefois, il convient de préciser qu'il est tout à fait possible de réaliser, de façon simultanée, sur le même substrat et dans le même empilement de couches, une pluralité de transistors.

Ceci est le cas en particulier lorsqu'on souhaite réaliser un circuit intégré formé d'un grand nombre de transistors. Dans ce cas, un masque avec une pluralité de motifs est formé sur l'empilement 101.

Après la mise en place du masque, on effectue une gravure de l'empilement 101, selon le motif du masque, avec arrêt sur la couche d'oxyde de grille 102. Lors de cette gravure on préserve une colonne 111 de l'empilement 101 visible sur la figure 4. Les flancs 112 de la colonne sont oxydés afin de les recouvrir d'une couche d'oxyde de flancs 114.

L'intérêt de la couche d'oxyde de flancs apparaît plus clairement à la figure 5.

La figure 5 montre la formation d'espaceurs latéraux 116 sur les flancs de la colonne 111 puis l'implantation d'impuretés dopantes autour de la colonne 111 pour former des régions implantées 118.

Les espaceurs latéraux 116 sont formés par un dépôt pleine plaque d'une couche de nitrure de silicium, puis par une gravure anisotrope de cette couche pour l'éliminer entièrement, à l'exception de la partie recouvrant les flancs de la colonne 111. Lors de cette étape, la couche 108 est légèrement entamée sur une épaisseur équivalente à la dispersion d'épaisseur après dépôt.

La couche d'oxyde de flancs 114, formée à l'étape précédente constitue une couche tampon entre le matériau de grille, en l'occurrence du polysilicium, et le nitrure de silicium des espaceurs latéraux. L'oxyde de flancs permet de relâcher les contraintes entre ces deux matériaux et en particulier les contraintes dues à des traitements thermiques ultérieurs du procédé.

L'implantation d'impuretés dopantes, de type n⁺, par exemple de phosphore ou d'arsenic ou encore de type p⁺, par exemple de bore ou d'indium, permet de former autour de la colonne une ou plusieurs régions 118 de silicium dopé dont la propriété est de s'oxyder plus rapidement que le silicium non dopé. A titre d'exemple pour un dopage n⁺ avec des atomes de phosphore et à une dose de 10²⁰ cm⁻³ le rapport de la vitesse d'oxydation du silicium dopé sur celle du silicium non dopé est de 3. Pour un dopage p⁺ de même concentration, le rapport de la vitesse d'oxydation du silicium dopé sur celle du silicium non dopé est de 2.

L'opération d'implantation est symbolisée sur la figure 5 par des flèches 119. Lors de cette implantation les couches de protection 106 et la couche entamée 108 protègent le matériau de grille. La colonne 111, dans son ensemble, constitue un masque qui empêche les impuretés implantées d'atteindre une portion de la couche de silicium 100 sous la colonne. Cette portion de couche de silicium, correspondant à la partie active du transistor, est repérée avec la référence 120.

Suite à l'implantation, on effectue une oxydation localisée de la partie dopée du silicium du substrat.

L'oxydation, qui est effectuée, par exemple, sous vapeur d'eau à une température de l'ordre de 950°C, permet de former une couche d'oxyde de champ 122 qui entoure la colonne 111. Cette couche est visible sur la figure 6.

On constate que la couche d'oxyde de champ 122 n'atteint pas le matériau de la couche de grille 104, ni l'oxyde 114, mais en est séparée, notamment par les espaceurs latéraux 116.

On peut noter en outre que la différence de vitesse d'oxydation des parties dopées par rapport aux parties non dopées permet d'éviter, à la limite de la couche 112, une déformation du type "bec d'oiseau" (bird's beak).

On obtient, après élimination des espaceurs latéraux 116 de nitrure de silicium et de la deuxième couche de protection 118, également en nitrure de silicium, la structure représentée à la figure 7.

Il convient de remarquer sur la figure 7 un espacement 124 qui sépare la couche d'oxyde de champ 122 du (ou des) flanc(s) 114 de la colonne 111. La taille de l'espacement 124 n'est pas dictée par les dimensions des motifs de réalisation du transistor (masques) mais dépend essentiellement de la taille des espaceurs latéraux précédemment formés (voir figure 6), de l'implantation d'ions (voir figure 5) et du temps d'oxydation permettant d'obtenir la couche d'oxyde 122.

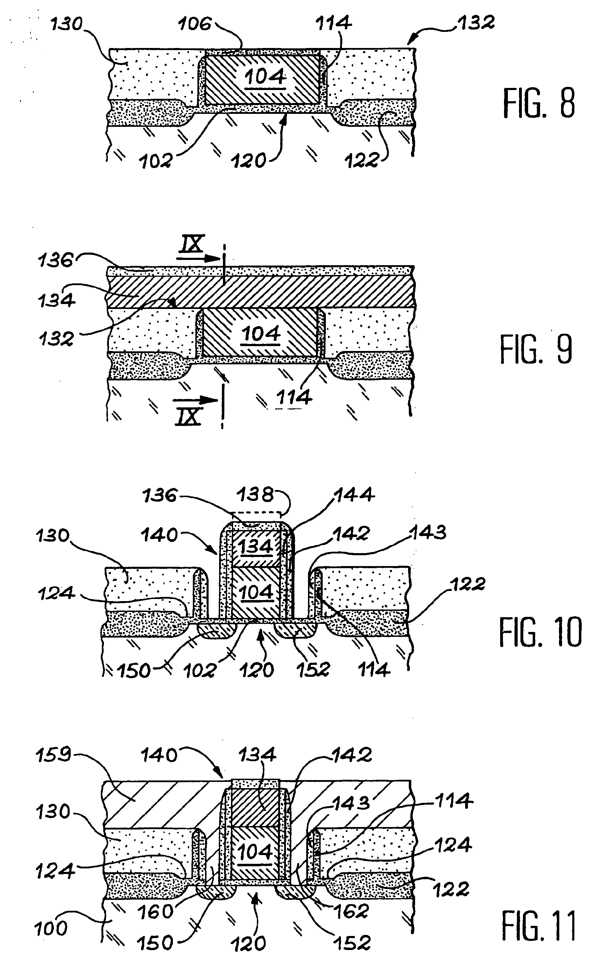

La figure 8 montre la formation autour de la colonne 111 d'une couche 130 de matériau isolant. La couche 130 présente une face supérieure 132 plane à laquelle affleure le sommet de la colonne 111. La couche 130 recouvre également les flancs de la colonne 111 et la couche d'oxyde de champ 122.

La couche 130 est formée par exemple par le dépôt pleine plaque d'une couche d'oxyde dopé tel que du verre PSG (Phosphosilicate Glass) ou du verre BPSG (Borophosphosilicate Glass), et par l'aplanissement de cette couche avec arrêt sur l'empilement de la colonne 111.

La fonction de la couche 130 est multiple. Elle fournit tout d'abord une isolation électrique du transistor que l'on réalise. Elle forme également une face supérieure 132 plane et permet d'éloigner de la région active du transistor une couche dite de shunt formée lors d'une étape ultérieure.

La formation de la couche de shunt 134 apparaît à la figure 9. Il s'agit, par exemple, d'une couche de silicium polycristallin et/ou d'une couche de siliciure de métal tel que du tungstène, formée sur la face supérieure plane 132. La couche de shunt vient en contact avec la couche de matériau de grille 104 qu'on a pris le soin de mettre à nu en éliminant de la première couche de protection 106.

La couche shunt 134 peut avantageusement être recouverte d'une couche 136 d'oxyde isolant. Cette couche permet d'isoler électriquement le dessus de la couche de shunt 134 par rapport à des prises de contact sur les source et drain du transistor, réalisées ultérieurement et décrites plus loin.

Comme évoqué précédemment, la couche de shunt peut, après une mise en forme, constituer une ligne d'adressage de la grille telle qu'une ligne de mots.

La mise en forme de la couche de shunt peut avoir lieu simultanément avec la formation d'une structure de grille. La structure de grille est indiquée avec la référence 140 sur la figure 10. On rappelle que la figure 10, de même que la figure 11 suivante, sont des coupes selon un plan perpendiculaire au plan de coupe des figures 3 à 9. Ce plan de coupe IX-IX est repéré sur la figure 9.

La structure de grille est gravée selon un deuxième masque de gravure 138, avec arrêt sur la couche 102 d'oxyde de grille. Le masque 138, formé sur la couche 136 est représenté sur la figure 10 en trait discontinu. Il s'agit, par exemple d'un masque de résine photosensible. Ce masque, formé au-dessus de la colonne 111 définit l'emplacement et la dimension de la structure de grille.

La gravure de la structure de grille est par exemple une gravure ionique réactive de type R.I.E. (Reactive Ion Etching). Elle est arrêtée à la fois par la couche d'oxyde de grille 102, la couche d'oxyde de flancs 114, recouvrant le (ou les) flanc(s) de la colonne (fig. 4 à 9) et par la couche d'isolation 130, également en oxyde. Ainsi, la structure de grille est autoalignée par rapport aux flancs de la couche 130 et des oxydes de flanc 114, provenant de la colonne gravée, et qui délimitent désormais les côtés latéraux de la couche 130, tournés vers la structure de grille. Les flancs 114 sont désignés, dans la suite du texte, par troisièmes flancs. L'autoalignement de la structure de grille est cependant indépendant du bord de la couche d'oxyde de champ 122 qui reste en retrait grâce à l'espacement 124.

Les flancs de la structure de grille, dits deuxièmes flancs et les troisièmes flancs, définis par la couche d'oxyde de flancs 114, sont recouverts d'espaceurs de nitrure de silicium 142, 143. Ces espaceurs, tout comme les espaceurs 116, sont formés par le dépôt d'une couche de nitrure de silicium puis par gravure anisotrope de cette couche.

Avantageusement, les deuxièmes flancs peuvent être recouverts d'une couche d'oxyde 144 tampon avant la formation des espaceurs. La couche d'oxyde 144 permet de libérer des contraintes pouvant apparaître entre les matériaux formant la structure de grille et l'espaceur 142 de nitrure de silicium, lors de traitements thermiques ultérieurs.

Une implantation d'ions, par exemple d'ions arsenic pour les transistors à canal n, à travers les parties de la couche d'oxyde de grille mises à nu lors de la gravure de la structure de grille, permet de former des régions de source 150 et 152 dans la région active 120. Lors de cette implantation, la structure de grille et la couche isolante 130 forment des masques d'implantation.

Les source et drain 150, 152 sont alignés sur les espaceurs latéraux 142 et 143 ainsi que sur la couche d'oxyde 114 formée en début de procédé. Ils ne sont pas alignés sur le bord de la couche d'isolation du champ 122 qui est en retrait. Cet aspect permet d'améliorer l'isolation électrique des transistors entre eux.

Une dernière étape du procédé, ainsi que le transistor finalement obtenu sont représentés à la figure 11.

La dernière étape correspond à la formation de prises de contact 160, 162 sur les source et drain. Elle comporte l'élimination des portions d'oxyde de grille 102 mises à nu lors de la gravure de la structure de grille, le dépôt conforme d'une couche de métal 159, son aplanissement et la mise en forme de cette couche. On peut noter qu'un risque de court-circuit entre la couche de métal 159 et la couche de shunt 134 est prévenu par les espaceurs latéraux isolants formés sur les flancs de la structure de grille et par la couche d'oxyde isolant 136 qui recouvre la couche de shunt.

Le métal de la couche 159, par exemple du tungstène, peut être déposé selon une technique de dépôt chimique en phase vapeur (CVD). L'aplanissement de la couche 159, par exemple, par un procédé de type polissage mécanochimique avec arrêt dans la couche 136, permet d'isoler les zones source et drain du transistor entre elles avant de procéder à la mise en forme de cette couche. Sa mise en forme selon des techniques classiques de photolithographie et de gravure permet de réaliser simultanément des interconnexions entre différents transistors ou composants d'un circuit intégré sur un même substrat.

Il apparaît aussi sur la figure 11 que le risque d'un empiétement des prises de contact 160, 162 sur la couche d'isolation de champ 122 est exclu par le procédé de l'invention. Ceci est notamment dû à l'espacement 124 dont la taille peut être contrôlée et constante indépendamment des motifs de gravure et des formes ou dimensions des transistors réalisés.

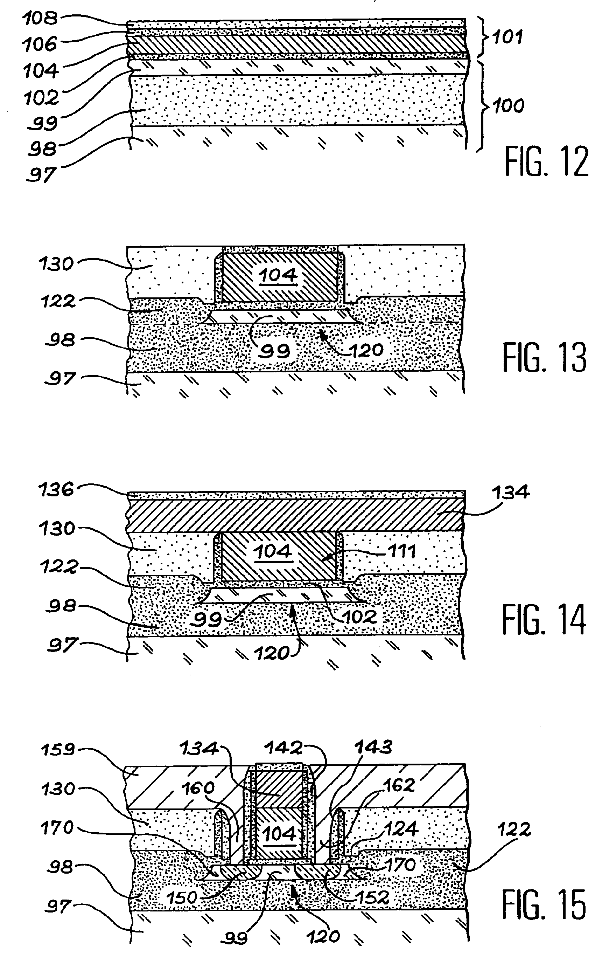

On décrit à présent une variante de mise en oeuvre du procédé sur un substrat de type silicium sur isolant illustrée par les figures 12 à 15. Les étapes du procédé demeurent sensiblement inchangées, ainsi, et les références numériques des éléments apparaissant aux figures 12 à 15 et correspondant à des éléments identiques ou similaires à ceux des figures 3 à 11 sont les mêmes. On peut ainsi, à leur sujet se reporter à la description qui précède.

Comme le montre la figure 12, on part d'un substrat 100 de type SOI comprenant une couche épaisse de support 97 en silicium, une couche dite enterrée 98 en oxyde de silicium et une couche dite superficielle 99 en silicium. La couche enterrée 98, isolante électrique, est disposée entre les couches 97 et 99 de silicium.

Sur le substrat SOI 100 on forme un empilement 101 comprenant une couche d'oxyde de grille 102, une couche de matériau de grille 104 et des couches de protection 106, 108. On peut à ce sujet se reporter aux explications de la figure 3.

La figure 13 correspond à la figure 8. Elle montre la structure obtenue après l'oxydation pour former la couche d'oxyde de champ 122, et après la formation de la couche 130 de matériau isolant.

Les étapes d'implantation et d'oxydation conduisant à la formation de la couche 122 d'oxyde de champ sont effectuées à une profondeur suffisante et sur une épaisseur suffisante pour que la couche 122 occupe toute l'épaisseur de la couche superficielle 99 du substrat SOI. La couche d'oxyde de champ 122 s'étend par conséquent jusque sur la couche enterrée 98, également isolante. Seule une portion de la couche superficielle 99, située sous la colonne 111, est préservée. Elle forme la partie active 120 du transistor.

La figure 14 correspond à la figure 9 et montre la formation de la couche de shunt.

La gravure de cette couche et la gravure de la colonne 111 pour former la grille sont effectués dans les mêmes conditions que celles décrites précédemment. La couche d'oxyde de grille 102 constitue une couche d'arrêt de gravure.

La figure 15, correspond à la figure précédente 11. Il s'agit d'une coupe selon le même plan de coupe que les figures 10 et 11.

Elle montre l'implantation des régions de source 150 et de drain 152 dans la portion de couche 99 préservée sous la colonne 111 (voir figure 14) et correspondant à la partie active 120.

Les source et drain 150, 152 sont auto-alignés sur les espaceurs latéraux 142 et 143 formés sur les deuxièmes et troisièmes flancs.

Ainsi, grâce à ces espaceurs et grâce à l'espacement 124 déjà décrit précédemment, les régions de source et de drain 150, 152 ne sont pas directement contre la couche d'oxyde de champ 122. Il reste entre les régions de source et de drain, et la couche d'oxyde de champ des portions de la couche 99 indiquées avec la référence 170. Grâce aux portions 170 des risques de courant de fuite et notamment de fuite par le fond de la couche 99, tournée vers la couche 98, sont réduits.

## Revendications

1. Procédé de réalisation d'un transistor à contacts auto-alignés sur un substrat, comprenant les étapes successives suivantes :
a) formation sur le substrat d'un empilement (101) de couches comprenant dans l'ordre une couche dite d'oxyde de grille (102) une couche de grille (104), et au moins une couche de protection (106,108),
b) formation d'un premier masque de gravure sur l'empilement, le masque présentant au moins un motif (110) correspondant à une région active d'un transistor, et gravure de l'empilement, selon le premier masque, avec arrêt sur la couche d'oxyde de grille, en préservant au moins une colonne (111) de l'empilement, correspondant à ladite zone active,
c) formation d'espaceurs latéraux (116) sur les flancs (112) de la colonne (111) et implantation d'impuretés dopantes aptes à favoriser une oxydation, dans une région du substrat de silicium non masquée par la colonne (111) et les espaceurs latéraux (116),
d) oxydation localisée du substrat de silicium dans la région implantée et élimination des espaceurs latéraux et de la couche de protection pour former une couche d'oxyde de champ (122),
e) dépôt d'une couche de matériau isolant (130) enrobant la colonne et polissage de la couche de matériau isolant avec arrêt sur la colonne de l'empilement,
f) formation sur la colonne (111) d'un deuxième masque (138) avec un motif de grille et gravure de la colonne (111) selon le deuxième masque avec arrêt sur la couche d'oxyde de grille (102) pour former une structure de grille (140) avec des deuxièmes flancs, et pour mettre à nu des troisièmes flancs délimitant la région active,
g) formation d'espaceurs latéraux isolants (142,143) auto-alignés sur les deuxième et troisième flancs, implantation de source et de drain (150,152) dans le substrat de silicium de part et d'autre de la structure de grille (140) dans des régions où l'oxyde de grille (102) est mis à nu par la gravure de la colonne, et
h) élimination de l'oxyde de grille mis à nu et formation de prises de contact (160,162) sur les source et drain, auto-alignées sur la structure de grille (140).

2. Procédé selon la revendication 1, **caractérisé en ce qu'**avant la formation d'espaceurs latéraux (116) sur les flancs de la colonne lors de l'étape c) on forme sur ces flancs une couche d'oxyde de flancs (114), le côté de la couche d'oxyde de flancs tourné vers la colonne étant mis à nu lors de l'étape f) pour former les troisièmes flancs délimitant la région active.

3. Procédé selon la revendication 2, **caractérisé en ce que** la couche de grille (104) étant une couche de silicium polycristallin, on forme la couche d'oxyde de flancs par oxydation en surface des flancs (112) de la colonne (111).

4. Procédé selon la revendication 1, **caractérisé en ce que** lors de l'étape c) on implante des impuretés conduisant à un dopage de type n ou p.

5. Procédé selon la revendication 1, **caractérisé en ce qu'**il comporte en outre après l'étape e) la formation d'une couche (134) dite de shunt, en contact avec la couche de grille (104) de la colonne (111) et recouvrant la couche de matériau isolant (130), le deuxième masque (138) étant formé au-dessus de la couche de shunt et la couche de shunt (134) étant également gravée lors de l'étape f) pour faire partie de la structure de grille (140).

6. Procédé selon la revendication 5, **caractérisé en ce qu'**on forme au-dessus de la couche de shunt (134) une couche isolante (136) électrique, le deuxième masque (138) étant formé au dessus de la couche isolante (136) la couche isolante électrique étant gravée avec la couche de shunt (134) lors de l'étape f).

7. Procédé selon la revendication 6, **caractérisé en ce que** la formation de prises de contact (160,162) comprend le dépôt conforme d'une couche de métal (159) venant en contact avec les source et drain (150,152), le polissage de la couche de métal avec arrêt sur la couche isolante électrique (136) recouvrant la couche de shunt (134), et la mise en forme de ladite couche de métal.

8. Procédé selon la revendication 1, **caractérisé en ce que** lors de l'étape a) on forme sur l'empilement une première couche de protection (106) d'oxyde de silicium et une deuxième couche de protection (108) de nitrure de silicium recouvrant la couche d'oxyde de silicium (106),
la deuxième couche de protection de nitrure de silicium (108) étant éliminée lors de l'étape d),
et la première couche de protection (106) étant éliminée lors de l'étapes e).

9. Procédé selon la revendication 1, **caractérisé en ce qu'**on utilise un substrat (100) de silicium massif.

10. Procédé selon la revendication 1, **caractérisé en ce qu'**on utilise un substrat (100) du type silicium sur isolant (SOI).

## Claims

1. Process for making a transistor with self-aligned contact points on a substrate, comprising the following successive steps:
a) formation on the substrate of multiple layers (101), comprising in order a "grid oxide" layer (102), a grid layer (104), and at least one protection layer (106, 108),
b) formation of a first etching mask on the multiple layer, the mask having at least one pattern (110) corresponding to an active region of a transistor, and etching of this multiple layer in accordance with the first mask, stopping on the grid oxide layer, and maintaining at least one column (111) of the multiple layer corresponding to the said active area,
c) formation of lateral spacers (116) on the sides (112) of the column (111) and implantation of doping impurities capable of facilitating oxidation in a region of the silicon substrate not masked by the column (111) and the lateral spacers (116),
d) local oxidation of the silicon substrate in the implanted region and elimination of lateral spacers and the protection layer, to form a field oxide layer (122),
e) deposit of a layer of insulating material (130) surrounding the column and polishing the layer of insulating material, stopping on the multiple layer column,
f) formation of a second mask (138) with a grid pattern on the column (111) and etching of the column (111) in accordance with the second mask, stopping on the grid oxide layer (102) to form a grid structure (140) with second sides, and to expose the third sides delimiting the active region,
g) formation of self-aligned insulating lateral spacers (142, 143) on the second and third sides, implantation of the source and drain (150, 152) in the silicon substrate on each side of the grid structure (140) and in regions in which the grid oxide (102) is exposed by etching of the column, and
h) elimination of the exposed grid oxide and formation of contact points (160, 162) on source and drain, self-aligned on the grid structure (140).

2. Process according to Claim 1, **characterized in that** before the formation of lateral spacers (116) on the sides of the column during step c), a side oxide layer (114) is formed on these sides, the edge of the side oxide layer facing the column being exposed during step f) to form third sides delimiting the active region.

3. Process according to Claim 2, **characterized in that** since the grid layer (104) is a layer of polycrystalline silicon, the side oxide layer is formed by surface oxidation of the sides (112) of column (111).

4. Process according to Claim 1, **characterized in that** impurities leading to an n type or p type doping are implanted in step c).

5. Process according to Claim 1, **characterized in that** it also comprises the formation of a "shunt" layer (134) in contact with the grid layer (104) of column (111) and covering the insulating material layer (130) after step e), the second mask (138) being formed above the shunt layer and the shunt layer (134) also being etched during step f) to form part of the grid structure (140).

6. Process according to Claim 5, **characterized in that** an electrical insulating layer (136) is formed above the shunt layer (134), the second mask (138) being formed above the insulating layer (136), the electrical insulating layer being etched with the shunt layer (134) during step f).

7. Process according to Claim 6, **characterized in that** the formation of contact points (160, 162) includes the conform deposit of a metal layer (159) coming into contact with the source and drain (150, 152), polishing of the metal layer stopping on the electrical insulating layer (136) covering the shunt layer (134), and shaping of the said metal layer.

8. Process according to Claim 1, **characterized in that** a first protection layer (106) of silicon oxide, and a second protection layer (108) of silicon nitride covering the layer of silicon oxide (106) are formed on the multiple layer during step a),
the second silicon nitride protection layer (108) being eliminated during step d)
and the first protection layer (106) being eliminated during step e).

9. Process according to Claim 1, **characterized in that** a solid silicon substrate (100) is used.

10. Process according to Claim 1, **characterized in that** a silicon on insulator (SOI) type substrate (100) is used.

## Patentansprüche

1. Verfahren zur Herstellung eines Transistors mit selbstausrichtenden Kontakten auf einem Substrat, die folgenden Schritte umfassend:
a) Bildung eines Schichtenstapels (101) auf dem Substrat, der sukzessiv eine sogenannte Gateoxidschicht (102), eine Gateschicht (104) und mindestens eine Schutzschicht (106,108) umfasst,
b) Bildung einer ersten Ätzmaske auf dem Stapel, wobei die Maske wenigstens ein einem aktiven Bereich eines Transistors entsprechendes Muster (110) aufweist, und Ätzung des Stapels gemäß der ersten Maske mit Stopp auf der Gateoxidschicht, wobei von dem Stapel wenigstens eine dem genannten aktiven Bereich entsprechende Säule (111) erhalten bleibt,
c) Bildung von seitlichen Spacern (116) auf den Flanken (112) der Säule (111) und Implantation von Dotierungsverunreinigungen, fähig eine Oxidation zu begünstigen, in einem nicht durch die Säule (111) und die seitlichen Spacer (116) maskierten Bereich des Siliciumsubstrats,
d) lokalisierte Oxidation des Siliciumsubstrats in dem implantierten Bereich und Elimination der seitlichen Spacer und der Schutzschicht, um eine Feldoxidschicht (122) zu bilden,
e) Abscheidung einer die Säule umgebenden Schicht aus isolierendem Material (130) und Politur der Schicht aus isolierenden Material mit Stopp auf der Säule des Stapels,
f) Bildung einer zweiten Maske (138) mit einem Gate-Muster auf der Säule (111) und Ätzung der Säule (111) gemäß der zweiten Maske mit Stopp auf der Gateoxidschicht (102), um eine Gate-Struktur (140) mit zweiten Flanken zu bilden und um dritte Flanken zu entblößen, welche den aktiven Bereich abgrenzen,
g) Bildung von selbstausrichtenden isolierenden seitlichen Spacern (142,143) auf den zweiten und dritten Flanken, Implantation von Source und Drain (150,152) in dem Siliciumsubstrat auf beiden Seiten der Gate-Struktur (140) in den Bereichen, wo das Gateoxid (102) durch die Ätzung der Säule entblößt ist, und
h) Eliminierung des entblößten Gateoxids und Bildung von Kontaktmitteln (160,162) auf Source und Drain, selbstausgerichtet auf die Gate-Struktur (140).

2. Verfahren nach Anspruch 1, **dadurch gekennzeichnet, dass** man vor der Bildung der seitlichen Spacer (116) auf den Flanken der Säule während des Schritts c) auf diesen Flanken eine Flankenoxidschicht (114) bildet, wobei die der Säule zugewandte Seite während des Schritts f) entblößt wird, um die den aktiven Bereich begrenzenden dritten Flanken zu bilden.

3. Verfahren nach Anspruch 2, **dadurch gekennzeichnet** - wobei die Gateschicht (104) eine Schicht aus polykristallinem Silicium ist -, dass man die Flankenoxidschicht durch Oberflächenoxidation der Flanken (112) der Säule (111) erzeugt.

4. Verfahren nach Anspruch 1, **dadurch gekennzeichnet, dass** man während des Schritts c) Verunreinigungen implantiert, die zu einer Dotierung des Typs n oder p führen.

5. Verfahren nach Anspruch 1, **dadurch gekennzeichnet, dass** es außerdem, nach dem Schritt e), die Erzeugung einer sogenannten Shuntschicht (134) umfasst, die Kontakt hat mit der Gateschicht (104) der Säule (111) und die Isoliermaterialschicht (130) bedeckt, wobei die zweite Maske (138) über der Shuntschicht gebildet wird und die Shuntschicht (134) während des Schritts f) auch geätzt wird, um Teil der Gate-Struktur (140) zu werden.

6. Verfahren nach Anspruch 5, **dadurch gekennzeichnet, dass** man über der Shuntschicht (134) eine elektrisch isolierende Schicht (136) erzeugt, wobei die zweite Maske (138) über der isolierenden Schicht (136) gebildet wird und die elektrisch isolierende Schicht während des Schritts f) mit der Shuntschicht (134) geätzt wird.

7. Verfahren nach Anspruch 6, **dadurch gekennzeichnet, dass** die Bildung von Kontaktmitteln (160,162) die konforme Abscheidung einer Metallschicht (159) im Kontakt mit Source und Drain (150,152), die Politur der Metallschicht mit Stopp auf der die Shuntschicht (134) bedeckenden elektrisch isolierenden Schicht (136) und die Formung der genannten Metallschicht umfasst.

8. Verfahren nach Anspruch 1, **dadurch gekennzeichnet, dass** man während des Schritts a) in dem Stapel eine erste Schutzschicht (106) aus Siliciumoxid und eine diese erste Schicht (106) bedeckende zweite Schutzschicht (108) aus Siliciumnitrid erzeugt,
wobei die zweite Schutzschicht aus Siliciumnitrid (108) während des Schritts d) eliminiert wird,
und die erste Schutzschicht (106) während des Schritts e) eliminiert wird.

9. Verfahren nach Anspruch 1, **dadurch gekennzeichnet, dass** man ein Substrat (100) aus massivem Silicium verwendet.

10. Verfahren nach Anspruch 1, **dadurch gekennzeichnet, dass** man ein Substrat (100) des Typs SOI (Silicon-on-Insulator) verwendet.
